# EUROPEAN PATENT APPLICATION

(11) **EP 2 602 834 A1**
(43) Date of publication of application: **12.06.2013**
(21) Application number: 10855607.7
(22) Date of filing: 03.08.2010
(51) Int. Cl.: H01L 31/04

(54) **SOLAR CELL**

(71) Applicant: Sharp Kabushiki Kaisha, Osaka-shi, Osaka 545-8522 (JP)
(72) Inventor: YAMAZAKI, Tsutomu, Osaka-shi Osaka 545-8522 (JP); FUNAKOSHI, Yasushi, Osaka-shi Osaka 545-8522 (JP)
(74) Representative: Müller - Hoffmann & Partner
(86) International application number: PCT/JP2010/063100
(87) International publication number: WO 2012/017517

(57) **Abstract**

A solar cell (8) includes a substrate (1, 121), and a plurality of strip-shaped p type impurity diffusion regions (3, 123) and a plurality of strip-shaped n type impurity diffusion regions (2, 122) in one surface of the substrate (1, 121) adjacently. The p type impurity diffusion region (3, 123) has an area ratio of not less than 60%, an area ratio larger than 80%, in particular, to the surface of the substrate (1, 121).

## Description

### TECHNICAL FIELD

The present invention relates to a solar cell.

### BACKGROUND ART

In recent years, solar cells that convert solar energy into electrical energy are increasingly, rapidly expected as an energy source for the next generation in view of preservation of the global environment in particular. While there are a variety of types of solar cells such as those using compound semiconductor, organic material or the like, those using silicon crystal are currently mainstream.

A type of solar cell currently most produced and sold is a bifacial solar cell having an n electrode on a surface thereof receiving solar light (i.e., a light-receiving surface), and a p electrode on a surface thereof opposite to the light-receiving surface (i.e., a back surface).

Furthermore, for example, Japanese Patent Laying-Open No. 2006-332273 (PTL 1) discloses a back electrode type solar cell, which does not have an electrode on a light receiving surface thereof and instead has an n electrode and a p electrode only on a back surface thereof opposite to the light receiving surface.

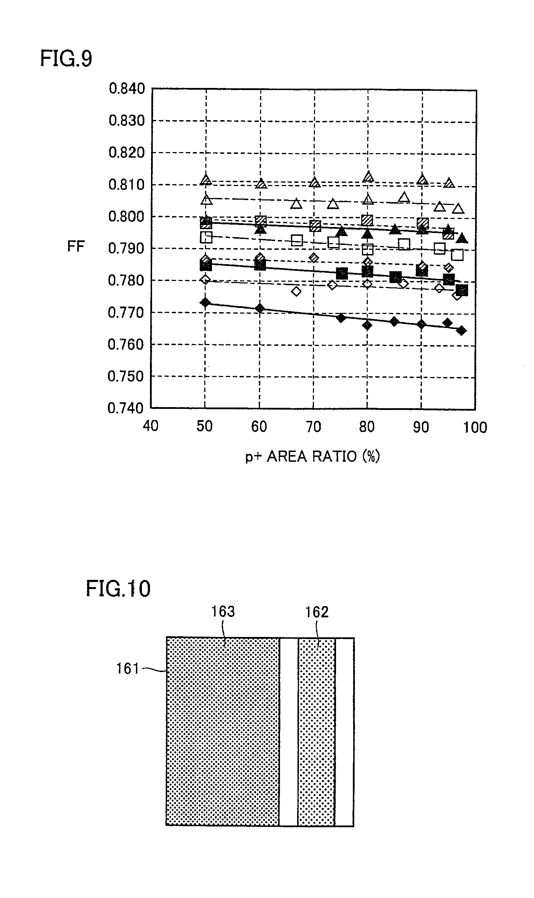

Fig. 10 is a schematic plan view of a pattern of an impurity diffusion region in a back surface of an n type silicon substrate of the back electrode type solar cell described in PTL 1.

PTL 1 describes a back electrode type solar cell including an n type silicon substrate 161 having a back surface with a single strip-shaped n type doped region 162 and a single strip-shaped p type doped region 163 together configuring a pattern of an impurity diffusion region. An n electrode is provided on n type doped region 162, and a p electrode is provided on p type doped region 163.

Note that while Fig. 10 shows only a single n type doped region 162 and only a single p type doped region 163 for the sake of illustration, in reality there exist a plurality of n type doped regions 162 and a plurality of p type doped regions 163, and n type doped regions 162 and p type doped regions 163 are disposed one by one alternately with a predetermined distance therebetween.

### CITATION LIST

### PATENT LITERATURE

PTL 1: Japanese Patent Laying-Open No. 2006-332273

### SUMMARY OF INVENTION

### TECHNICAL PROBLEM

While PTL 1 describes that p type doped region 163 having an area ratio of not less than 60% and not more than 80% allows a back electrode type solar cell to have high conversion efficiency, there is a demand for a solar cell having further constant, increased conversion efficiency.

In view of the above circumstances, an object of the present invention is to provide a solar cell having further constant, increased conversion efficiency.

### SOLUTION TO PROBLEM

The present invention provides a solar cell including: a substrate; a plurality of strip-shaped p type impurity diffusion regions and a plurality of strip-shaped n type impurity diffusion regions provided in one surface of the substrate adjacently; and an electrode for n type on the n type impurity diffusion region, the p type impurity diffusion region having an area ratio of not less than 60% to the surface of the substrate, the p type impurity diffusion regions that are adjacent being spaced by not more than 400 µm.

Herein in the present solar cell preferably the electrode for n type is spaced from another, adjacent electrode for n type by not less than 1 mm.

Furthermore, the present invention provides a solar cell including: a substrate; and a plurality of strip-shaped p type impurity diffusion regions and a plurality of strip-shaped n type impurity diffusion regions provided in one surface of the substrate adjacently, the p type impurity diffusion region having an area ratio of larger than 80% to the surface of the substrate, the p type impurity diffusion regions that are adjacent being spaced by not more than 400 µm.

Furthermore in the present solar cell preferably the p type impurity diffusion regions that are adjacent are spaced by not less than 100 µm.

Furthermore in the present solar cell preferably the p type impurity diffusion region has the area ratio of not more than 90%.

### ADVANTAGEOUS EFFECTS OF INVENTION

The present invention can thus provide a solar cell having further constant, increased conversion efficiency.

### BRIEF DESCRIPTION OF DRAWINGS

Fig. 1 is a schematic cross sectional view of an example of a back electrode type solar cell that is an example of a solar cell of the present invention.
Fig. 2(a) to Fig. 2(g) are schematic cross sectional views for illustrating an example of a method for producing the back electrode type solar cell shown in Fig. 1.
Fig. 3 is a schematic plan view of a back surface of a substrate of the back electrode type solar cell shown in Fig. 1.
Fig. 4 is a schematic cross sectional view of a back electrode type solar cell used in a simulation.
Fig. 5 represents a result of an assessment of a relationship between a back electrode type solar cell's short circuit current density and base width in a simulation.
Fig. 6 represents a result of an assessment of a relationship between a back electrode type solar cell's short circuit current density and p+ area ratio in a simulation.
Fig. 7 represents a result of an assessment of a relationship between a back electrode type solar cell's open circuit voltage and p+ area ratio in a simulation.
Fig. 8 represents a result of an assessment of a relationship between a back electrode type solar cell's conversion efficiency and p+ area ratio in a simulation.
Fig. 9 represents a relationship between a back electrode type solar cell's FF and p+ area ratio.
Fig. 10 is a schematic plan view of a pattern of an impurity diffusion region in a back surface of an n type silicon substrate of a back electrode type solar cell described in PTL 1.

### DESCRIPTION OF EMBODIMENTS

Hereinafter, the present invention will be described in embodiments. Note that in the present invention, identical reference characters denote identical or corresponding components.

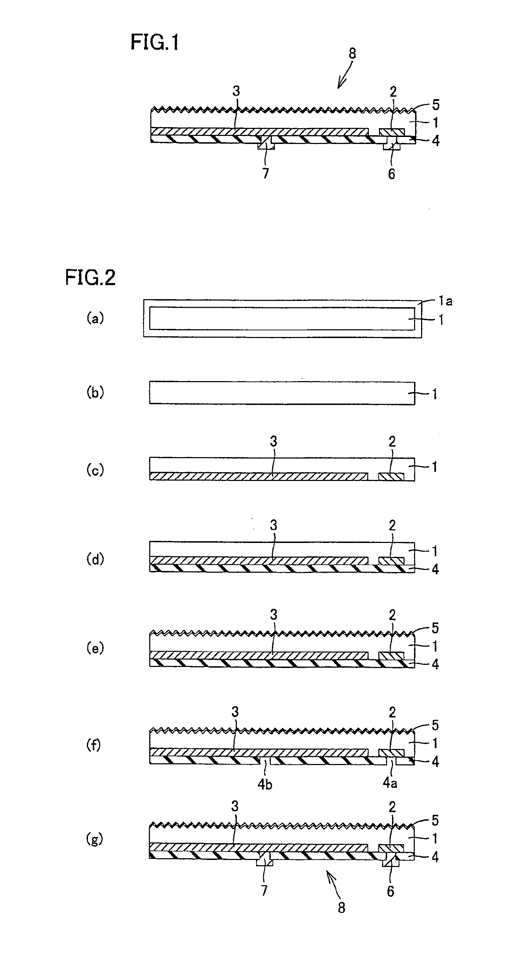

Fig. 1 is a schematic cross sectional view of an example of a back electrode type solar cell that is an example of a solar cell of the present invention.

A back electrode type solar cell 8 includes a substrate 1 formed of n type silicon, an n type impurity diffusion region 2 and a p type impurity diffusion region 3 that are provided in a back surface of substrate 1, an electrode for n type 6 provided in contact with n type impurity diffusion region 2, and an electrode for p type 7 provided in contact with p type impurity diffusion region 3.

Back electrode type solar cell 8 has substrate 1 with a light receiving surface provided with a textured structure or a similar uneven structure covered with an anti-reflection film 5. Furthermore, back electrode type solar cell 8 has substrate 1 with a back surface provided with a passivation film 4.

Note that while Fig. 1 shows only a single n type impurity diffusion region 2 and only a single p type impurity diffusion region 3 for the sake of illustration, in reality there exist a plurality of n type impurity diffusion regions 2 and a plurality of p type impurity diffusion regions 3, and n type impurity diffusion regions 2 and p type impurity diffusion regions 3 are disposed one by one alternately with a predetermined distance therebetween.

Hereinafter reference will be made to Fig. 2(a) to Fig. 2(g) to describe one example of a method for producing back electrode type solar cell 8 shown in Fig. 1

Initially, as shown in Fig. 2(a), for example an n type polycrystalline silicon or monocrystalline silicon ingot is sliced to prepare substrate 1 having a surface with a slicing damage 1a.

Then, as shown in Fig. 2(b), slicing damage 1a on the surface of substrate 1 is removed. Slicing damage 1a can be removed for example by etching the surface of the sliced substrate 1 with an aqueous solution of hydrogen fluoride and nitric acid mixed together, an alkaline aqueous solution of sodium hydroxide or the like, or the like.

Although substrate 1 with slicing damage 1a removed therefrom is not limited to any specific size or geometry, substrate 1 can have a thickness for example of not less than 100 µm and not more than 500 µm, preferably about 200 µm in particular.

Then, as shown in Fig. 2(c), n type impurity diffusion region 2 and p type impurity diffusion region 3 are provided in the back surface of substrate 1.

N type impurity diffusion region 2 can be provided for example through application diffusion using an impurity diffusion agent containing an n type impurity, vapor phase diffusion using a gas containing an n type impurity, or the like.

P type impurity diffusion region 3 can be provided for example through application diffusion using an impurity diffusion agent containing a p type impurity, vapor phase diffusion using a gas containing a p type impurity, or the like.

N type impurity diffusion region 2 is not limited in particular except that it is a region that contains an n type impurity and exhibits the n type conduction type. Note that the n type impurity can for example be phosphorus or a similar n type impurity.

P type impurity diffusion region 3 is not limited in particular except that it is a region that contains a p type impurity and exhibits the p type conduction type. Note that the p type impurity can for example be boron, aluminum or a similar p type impurity.

Then, as shown in Fig. 2(d), passivation film 4 is provided on the back surface of substrate 1. Herein, passivation film 4 can be provided for example in a thermal oxidation method, a plasma chemical vapor deposition (plasma CVD) method or the like.

Passivation film 4 can be, but not limited to, silicon oxide film, silicon nitride film, silicon oxide film and silicon nitride film stacked in layers, or the like.

Passivation film 4 can have a thickness for example of not less than 0.05 µm and not more than 1 µm, preferably about 0.2 µm in particular.

Then, as shown in Fig. 2(e), a textured structure or a similar, uneven structure is provided throughout the light receiving surface of substrate 1, and subsequently, anti-reflection film 5 is provided on the uneven structure.

The textured structure can be formed for example by etching the light receiving surface of substrate 1. The textured structure can be provided by etching the light receiving surface of substrate 1 with an etching liquid that is a liquid of an alkaline aqueous solution for example of sodium hydroxide, potassium hydroxide or the like with isopropyl alcohol added thereto and is heated for example to not less than 70°C and not more than 80°C.

Anti-reflection film 5 can be provided for example in a plasma CVD method or the like. Note that anti-reflection film 5 can for example be, but not limited to, silicon nitride film or the like.

Then, as shown in Fig. 2(f), passivation film 4 on the back surface of substrate 1 is partially removed to provide a contact hole 4a and a contact hole 4b. Herein, contact hole 4a is provided so as to expose at least a portion of a surface of n type impurity diffusion region 2, and contact hole 4b is provided so as to expose at least a portion of a surface of p type impurity diffusion region 3.

Contact hole 4a and contact hole 4b can be provided for example as follows: photolithography is employed to provide on passivation film 4 a resist pattern having an opening at a portion corresponding to a location at which contact hole 4a and contact hole 4b are provided, and subsequently, passivation film 4 is etched through the opening of the resist pattern; or an etching paste is applied to a portion of passivation film 4 that corresponds to a location at which contact hole 4a and contact hole 4b are provided, and the etching paste is then heated to etch passivation film 4; or a similar method is employed.

Then, as shown in Fig. 2(g), an electrode for n type 6 is provided in contact with n type impurity diffusion region 2 through contact hole 4a and an electrode for p type 7 is provided in contact with p type impurity diffusion region 3 through contact hole 4b, and back electrode type solar cell 8 is thus completed.

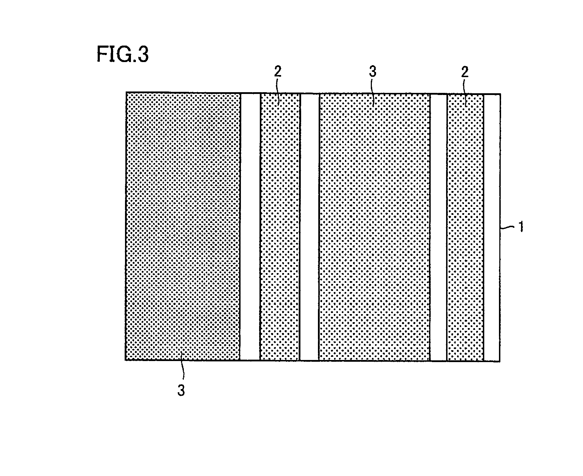

Fig. 3 is a schematic plan view of a back surface of substrate 1 of back electrode type solar cell 8 produced as described above. Substrate 1 has a back surface with p type impurity diffusion region 3 in the form of a strip and n type impurity diffusion region 2 in the form of a strip disposed therein one by one alternately with a predetermined distance therebetween, and a plurality of n type impurity diffusion regions 2 and a plurality of p type impurity diffusion regions 3 are thus provided

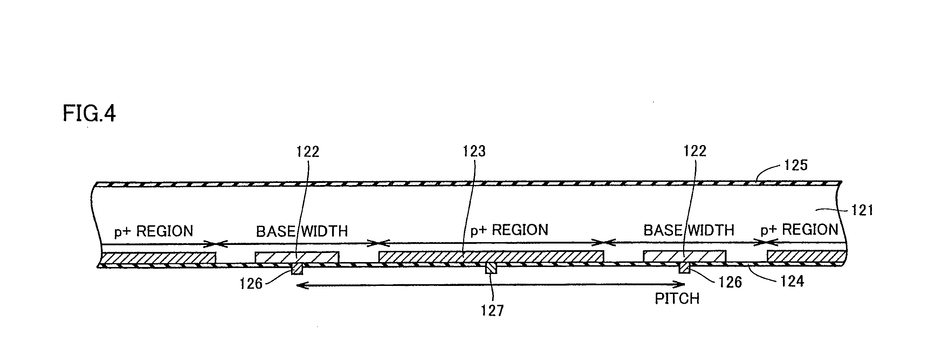

The back electrode type solar cell thus configured has characteristics, which were studied through simulation using a 2D device simulator. Fig. 4 is a schematic cross sectional view of a back electrode type solar cell used in a simulation.

Herein, the back electrode type solar cell shown in Fig. 4 is configured to have: an n type silicon substrate 121 (thickness: 200 µm, n type impurity concentration: 2 x 10¹⁵ cm⁻³); an n+ region 122 (n type impurity concentration: 1 x 10²⁰ cm⁻³) that is a strip-shaped n type impurity diffusion region provided in the back surface of n type silicon substrate 121; a p+ region 123 (p type impurity concentration: 1 x 10¹⁹ cm⁻³) that is a strip-shaped p type impurity diffusion region spaced from n+ region 122, as predetermined; an electrode for n type 126 provided in contact with n+ region 122; and an electrode for p type 127 provided in contact with p+ region 123. Herein, n+ region 122 and p+ region 123 are provided in strips extending in a direction perpendicular to the plane of the sheet of Fig. 4, and are disposed alternately and periodically in the widthwise direction of n type silicon substrate 121 (i.e., a rightward/leftward direction in Fig. 4).

Furthermore, the back electrode type solar cell shown in Fig. 4 is configured to have an anti-reflection film 125 on a light receiving surface of n type silicon substrate 121, and a passivation film 124 on the back surface of n type silicon substrate 121 other than the regions of electrode for n type 126 and electrode for p type 127.

Then, a carrier recombination rate on the back surface of n type silicon substrate 121 in a region other than n+ region 122 and p+ region 123 was set at 10 cm/s, and a carrier recombination rate on the back surface of n type silicon substrate 121 at a surface of n+ region 122 was set at 1 x 10⁴ cm/s and a carrier recombination rate on the back surface of n type silicon substrate 121 at a surface of p+ region 123 was set at 5 x 10⁴ cm/s.

Note that the back electrode type solar cell shown in Fig. 4 has a base width and a pitch: the former indicates a spacing of adjacent p+ regions 123 in the widthwise direction of the back surface of n type silicon substrate 121, and the latter indicates a spacing of adjacent electrodes for n type 126 in the widthwise direction of the back surface of n type silicon substrate 121. In other words, a pitch is represented by the sum of the width of a single p+ region 123 and the base width, and as the width of p+ region 123 is obtained by dividing the area of p+ region 123 by the length of p+ region 123, the pitch, the base width, and the area ratio of p+ region 123 have a correlation.

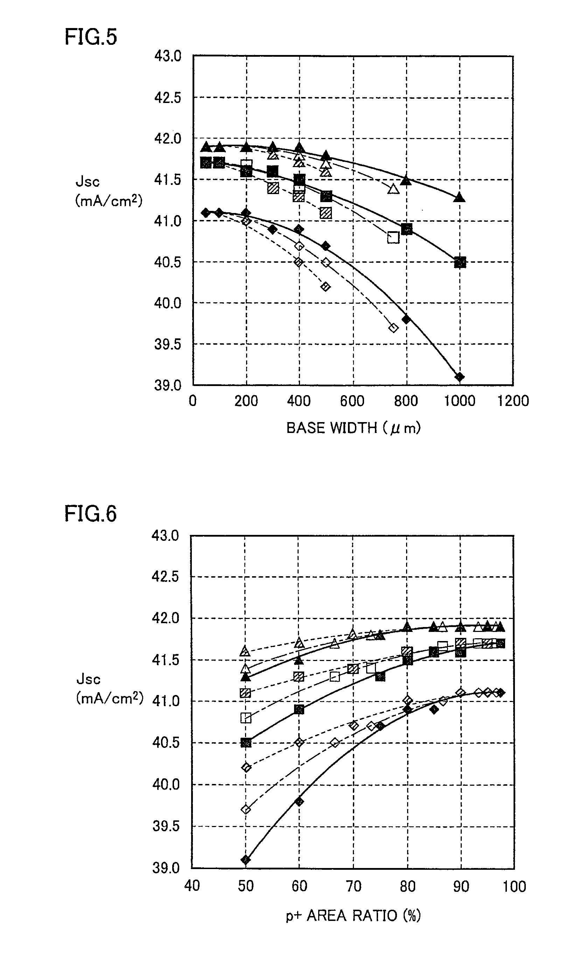

The back electrode type solar cell configured as described above was assessed through simulation regarding a relationship between its short circuit current density (Jsc) and base width (i.e., the spacing of adjacent p+ regions 123). The result is shown in Fig. 5.

Note that the back electrode type solar cell was assessed for short circuit current density (Jsc) under the following conditions: n type silicon substrate 121 internally had a carrier lifetime τ varying between 2.0 milliseconds (ms), 1.0 ms and 0.5 ms and adjacent electrodes for n type 126 had a pitch varying between 1 mm, 1.5 mm and 2 mm, and for each case, the base width was varied.

Note that in Fig. 5, the axis of ordinate represents the back electrode type solar cell's short circuit current density (Jsc), and the axis of abscissa represents its base width (µm). Furthermore, in Fig. 5, a triangular symbol, a square symbol, and a rhomboidal symbol represent short circuit current density (Jsc) (mA/cm²) for carrier lifetimes τ of 2.0 ms, 1.0 ms and 0.5 ms, respectively, and a hatched symbol, a hollow symbol and a solid symbol correspond to the pitches of 1 mm, 1.5 mm, and 2 mm, respectively.

As shown in Fig. 5, it can be seen that for any of carrier lifetimes τ of 2.0 ms, 1.0 ms and 0.5 ms, the back electrode type solar cell has larger short circuit current density with smaller base width. More specifically, a tendency has been observed that short circuit current density is large in the case where the base width is not more than 400 µm, and, in particular, it has been found that large short circuit current density can be maintained in the case where the base width is not more than 200 µm.

From the above result, it has been found that, to allow the back electrode type solar cell to have large short circuit current density, it is preferable that a base width that is a pitch between adjacent p+ regions 123 is not more than 400 µm, not more than 200 µm in particular.

The back electrode type solar cell configured as described above was then assessed through simulation regarding a relationship between its short circuit current density (Jsc) and p+ area ratio (a ratio of a total in area of p+ regions 123 to the area of the entirety of the back surface of n type silicon substrate 121) (%). The result is shown in Fig. 6.

Note that the short circuit current density (Jsc) of the back electrode type solar cell was assessed under the following conditions: n type silicon substrate 121 internally had carrier lifetime τ varying between 2.0 ms, 1.0 ms and 0.5 ms and adjacent electrodes for n type 126 had a pitch varying between 1 mm, 1.5 mm and 2 mm, and for each case, the p+ area ratio was varied.

Note that in Fig. 6, the axis of ordinate represents the back electrode type solar cell's short circuit current density (Jsc), and the axis of abscissa represents its p+ area ratio (%). Furthermore, in Fig. 6, a triangular symbol, a square symbol, and a rhomboidal symbol represent short circuit current density (Jsc) (mA/cm²) for carrier lifetimes τ of 2.0 ms, 1.0 ms and 0.5 ms, respectively, and a hatched symbol, a hollow symbol and a solid symbol correspond to the pitches of 1 mm, 1.5 mm, and 2 mm, respectively.

As shown in Fig. 6, it can be seen that for any of carrier lifetimes τ of 2.0 ms, 1.0 ms and 0.5 ms, the back electrode type solar cell has larger short circuit current density with larger p+ area ratio. More specifically, a tendency has been observed that short circuit current density was large in the case where the p+ area ratio is not less than 60%, and is larger than 80% in particular. Note, however, that a tendency was observed that the short circuit current density does not increase substantially in the case where the p+ area ratio exceeds 90%.

From the above result, it has been found that, to allow the back electrode type solar cell to have large short circuit current density, it is preferable that a ratio of a total in area of p+ regions 123 to the area of the entirety of the back surface of n type silicon substrate 121, i.e., the p+ area ratio, is not less than 60%, and is larger than 80% in particular. Furthermore, it has also been found that the upper limit of the p+ area ratio to allow the back electrode type solar cell to have large short circuit current density is 90%.

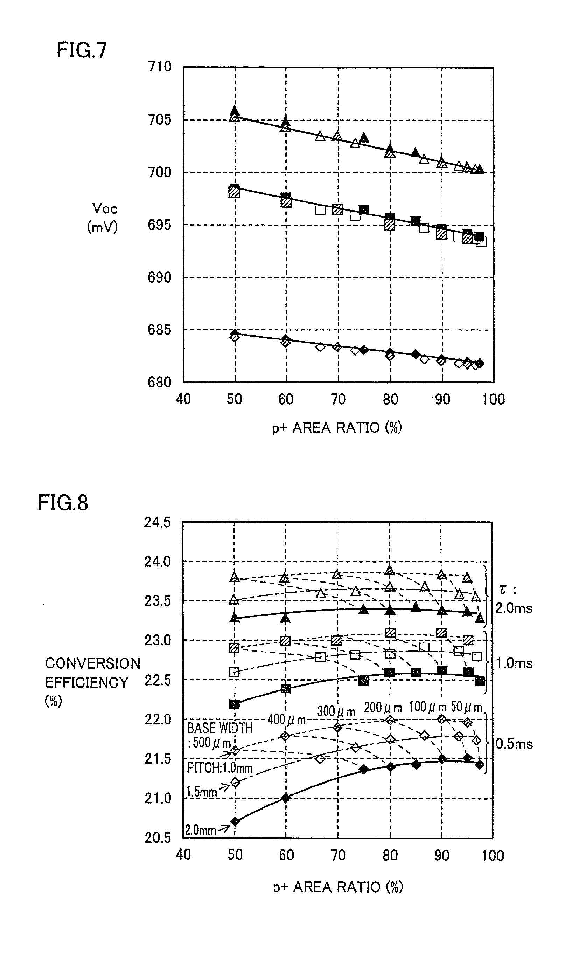

The back electrode type solar cell configured as described above was then assessed through simulation regarding a relationship between its open circuit voltage (Voc) and p+ area ratio (%). The result is shown in Fig. 7.

Note that the open circuit voltage (Voc) was assessed under the following conditions: n type silicon substrate 121 internally had carrier lifetime τ varying between 2.0 ms, 1.0 ms and 0.5 ms and adjacent electrodes for n type 126 had a pitch varying between 1 mm, 1.5 mm and 2 mm, and for each case, the p+ area ratio was varied.

Note that in Fig. 7, the axis of ordinate represents the back electrode type solar cell's open circuit voltage (Voc), and the axis of abscissa represents its p+ area ratio (%). Furthermore, in Fig. 7, a triangular symbol, a square symbol, and a rhomboidal symbol represent open circuit voltage (Voc) (mV) for carrier lifetimes τ of 2.0 ms, 1.0 ms and 0.5 ms, respectively, and a hatched symbol, a hollow symbol and a solid symbol correspond to the pitches of 1 mm, 1.5 mm, and 2 mm, respectively.

As shown in Fig. 7, it can be seen that for any of carrier lifetimes τ of 2.0 ms, 1.0 ms and 0.5 ms, the back electrode type solar cell has an open circuit voltage monotonously decreasing as the p+ area ratio increases.

From the above result, it has been found that, to allow the back electrode type solar cell to have high open circuit voltage, it is preferable that the p+ area ratio is minimized.

Then, from the results shown in Fig. 6 and Fig. 7, the back electrode type solar cell configured as described above was assessed through simulation regarding a relationship between its conversion efficiency (%) and p+ area ratio (%). The result is shown in Fig. 8.

Note that the conversion efficiency was assessed under the following conditions: n type silicon substrate 121 internally had carrier lifetime τ varying between 2.0 ms, 1.0 ms and 0.5 ms and adjacent electrodes for n type 126 had a pitch varying between 1 mm, 1.5 mm and 2 mm, and for each case, the p+ area ratio (base width) was varied.

Note that in Fig. 8, the axis of ordinate represents the back electrode type solar cell's conversion efficiency (%), and the axis of abscissa represents its p+ area ratio (%). Furthermore, in Fig. 8, a triangular symbol, a square symbol, and a rhomboidal symbol represent conversion efficiency (%) for carrier lifetimes τ of 2.0 ms, 1.0 ms and 0.5 ms, respectively, and a hatched symbol, a hollow symbol and a solid symbol correspond to the pitches of 1 mm, 1.5 mm, and 2 mm, respectively.

The conversion efficiency shown in Fig. 8 was calculated from the product of the short circuit current density shown in Fig. 6, the open circuit voltage shown in Fig. 7, and the fill factor (FF) shown in Fig. 9 for conditions each with at least one of the p+ area ratio (base width), the carrier lifetime and the pitch varied. The FF shown in Fig. 9 was obtained from a current-voltage curve obtained through simulation for each condition for which the back electrode type solar cell's conversion efficiency was calculated. Note that in Fig. 9, the axis of ordinate represents the back electrode type solar cell's FF, and the axis of abscissa represents its p+ area ratio (%).

As shown in Fig. 8, a tendency has been confirmed that for each of carrier lifetimes τ of 0.5 ms, 1.0 ms and 2.0 ms, and a pitch varying in a range of 1 mm to 2 mm, the back electrode type solar cell has conversion efficiency constantly exhibiting a large value in the case where the p+ area ratio is not less than 60%, the p+ area ratio is larger than 80% in particular. On the other hand, a tendency has also been confirmed that in the case where the p+ area ratio exceeds 90%, the conversion efficiency does not increase, or decreases.

Accordingly, from the result shown in Fig. 8, a p+ area ratio of at least 60%, preferably larger than 80% in particular is preferable to allow the back electrode type solar cell to have high conversion efficiency constantly. Furthermore, a p+ area ratio of not more than 90% is more preferable to allow the back electrode type solar cell to have high conversion efficiency further constantly.

Furthermore, in Fig. 8, each broken line connecting hatched, hollow and solid symbols indicates a single base width, and for each of carrier lifetimes τ of 0.5 ms, 1.0 ms and 2.0 ms, the broken lines indicate base widths of 50 µm, 100 µm, 200 µm, 300 µm, 400 µm, and 500 µm, respectively, from rightward to leftward in Fig. 8.

As shown in Fig. 8, a tendency has been confirmed that, for carrier lifetimes τ of 0.5 ms, 1.0 ms and 2.0 ms and pitches of 1 mm, 1.5 mm and 2 mm, the back electrode type solar cell has larger conversion efficiency with smaller base width and has conversion efficiency constantly exhibiting a large value with a base width of not more than 400 µm in particular. On the other hand, a tendency has also been confirmed that, in the case where the base width is larger than 100 µm, the base width is larger than 200 µm in particular, the conversion efficiency does not increase, or decreases.

Accordingly, from the result shown in Fig. 8, a base width of not more than 400 µm is preferable to allow the back electrode type solar cell to have high conversion efficiency constantly. Furthermore, a base width of not less than 100 µm is preferable to allow the back electrode type solar cell to have high conversion efficiency further constantly. Note that the base width of not less than 100 µm is also preferable in view of forming n+ region 122 and the electrode for n type 126 with good repeatability.

From the above simulation result it is believed that, in the case where carrier lifetime τ is at least 0.5 ms to 2.0 ms and the pitch is at least 1 mm to 2 mm, a back electrode type solar cell having a p+ area ratio of not less than 60%, a p+ area ratio larger than 80% in particular, and a base width of not more than 400 µm, can have high conversion efficiency constantly.

Furthermore, a p+ area ratio of not more than 90% is more preferable to allow the back electrode type solar cell to have high conversion efficiency further constantly.

Furthermore, a base width of not less than 100 µm is preferable to allow the back electrode type solar cell to have high conversion efficiency further constantly.

It should be understood that the embodiment disclosed herein is illustrative and non-restrictive in any respect. The scope of the present invention is defmed by the terms of the claims, rather than the description above, and is intended to include any modifications within the scope and meaning equivalent to the terms of the claims.

### INDUSTRIAL APPLICABILITY

The present invention can be utilized for solar cells.

### REFERENCE SIGNS LIST

1: substrate; 1a: slicing damage; 2: n type impurity diffusion region; 3: p type impurity diffusion region; 4: passivation film; 5: anti-reflection film; 6: electrode for n type; 7: electrode for p type; 8: back electrode type solar cell; 121: n type silicon substrate; 122: n+ region; 123: p+ region; 124: passivation film; 125: anti-reflection film; 126: electrode for n type; 127: electrode for p type; 161: n type silicon substrate; 162: n type doped region; 163: p type doped region.

## Claims

1. A solar cell (8) comprising:
a substrate (1, 121);
a plurality of strip-shaped p type impurity diffusion regions (3, 123) and a plurality of strip-shaped n type impurity diffusion regions (2, 122) provided in one surface of said substrate (1, 121) adjacently; and
an electrode for n type (6, 126) on said n type impurity diffusion region (2, 122),
said p type impurity diffusion region (3, 123) having an area ratio of not less than 60% to said surface of said substrate (1, 121),
said p type impurity diffusion regions (3, 123) that are adjacent being spaced by not more than 400 µm.

2. The solar cell (8) according to claim 1, wherein said electrode for n type (6, 126) is spaced from another, adjacent said electrode for n type (6, 126) by not less than 1 mm.

3. A solar cell (8) comprising:
a substrate (1, 121); and
a plurality of strip-shaped p type impurity diffusion regions (3, 123) and a plurality of strip-shaped n type impurity diffusion regions (2, 122) provided in one surface of said substrate (1, 121) adjacently,
said p type impurity diffusion region (3, 123) having an area ratio of larger than 80% to said surface of said substrate (1, 121),
said p type impurity diffusion regions (3, 123) that are adjacent being spaced by not more than 400 µm.

4. The solar cell (8) according to any of claims 1 to 3, wherein said p type impurity diffusion regions (3, 123) that are adjacent are spaced by not less than 100 µm.

5. The solar cell (8) according to any of claims 1 to 4, wherein said p type impurity diffusion region (3, 123) has said area ratio of not more than 90%.

## Amended claims

### Amended claims under Art. 19.1 PCT

**1.** (Amended) A solar cell (8) comprising:
a substrate (1, 121);
a plurality of strip-shaped p type impurity diffusion regions (3, 123) and a plurality of strip-shaped n type impurity diffusion regions (2, 122) provided in one surface of said substrate (1, 121) adjacently; and
an electrode for n type (6, 126) on said n type impurity diffusion region (2, 122),
said p type impurity diffusion region (3, 123) having an area ratio of not less than 60% to said surface of said substrate (1, 121),
said p type impurity diffusion regions (3, 123) that are adjacent being spaced by not more than 400 µm,
said electrode for n type (6, 126) being spaced from another, adjacent said electrode for n type (6, 126) by not less than 1 mm.

**2.** (Cancelled)

**3.** A solar cell (8) comprising:
a substrate (1, 121); and
a plurality of strip-shaped p type impurity diffusion regions (3, 123) and a plurality of strip-shaped n type impurity diffusion regions (2, 122) provided in one surface of said substrate (1, 121) adjacently,
said p type impurity diffusion region (3, 123) having an area ratio of larger than 80% to said surface of said substrate (1, 121),
said p type impurity diffusion regions (3, 123) that are adjacent being spaced by not more than 400 µm.

**4.** The solar cell (8) according to any of claims 1 to 3, wherein said p type impurity diffusion regions (3, 123) that are adjacent are spaced by not less than 100 µm.

**5.** The solar cell (8) according to any of claims 1 to 4, wherein said p type impurity diffusion region (3, 123) has said area ratio of not more than 90%.
